(19) Europäisches Patentamt
European Patent Office
Office européen des brevets

(11) Veröffentlichungsnummer: **0 115 021**
**B1**

(12) # EUROPÄISCHE PATENTSCHRIFT

(45) Veröffentlichungstag der Patentschrift: **20.09.89**

(51) Int. Cl.$^4$: **G 03 F 7/02**

(21) Anmeldenummer: **83112806.1**

(22) Anmeldetag: **20.12.83**

(54) **Positiv arbeitendes Verfahren zur Herstellung von Relief- und Druckformen.**

(30) Priorität: **28.12.82 DE 3248246**

(43) Veröffentlichungstag der Anmeldung: **08.08.84 Patentblatt 84/32**

(45) Bekanntmachung des Hinweises auf die Patenterteilung: **20.09.89 Patentblatt 89/38**

(84) Benannte Vertragsstaaten: **AT BE CH DE FR GB IT LI NL**

(56) Entgegenhaltungen:
**US-A- 3 556 794**
**RESEARCH DISCLOSURE, Nr. 158, Juni 1977, Seite 70, Nr. 15868, Havant, Hampshire, GB; R.E. GILSON: "A reversable negative working lithoplate"**
**RESEARCH DISCLOSURE, Nr. 156, April 1977, Seiten 65-68, Nr. 15613, Havant, Hampshire, GB; J.A. VAN ALLAN et al.: "Sensitizers for photocrosslinkable polymers"**

(73) Patentinhaber: **BASF Aktiengesellschaft**
**Carl-Bosch-Strasse 38**
**D-6700 Ludwigshafen (DE)**

(72) Erfinder: **Bronstert, Bernd, Dr.**
**Zanderstrasse 35**
**D-6701 Otterstadt (DE)**
Erfinder: **Hoffmann, Gerhard, Dr.**
**Pappelstrasse 22**
**D-6701 Otterstadt (DE)**
Erfinder: **Lynch, John, Dr.**
**Bachusstrasse 15**
**D-6521 Monsheim (DE)**

**EP 0 115 021 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue St-Denis, 75001 Paris, France

## Beschreibung

Die Erfindung betrifft ein positiv arbeitendes Verfahren zur Herstellung von Relief- und/oder Druckformen, bei dem man in einer lichtempfindlichen, photopolymerisierbaren Schicht durch eine bildmäßige Belichtung Bereiche erzeugt, in denen die Polymerisationsfähigkeit unterdrückt ist, durch eine weitere Belichtung die noch polymerisationsfähigen Bereiche der Schicht polymerisiert und anschließend die Relief- und/oder Druckform durch Entfernen der nichtpolymerisierten Schichtanteile entwickelt.

Die bekannten lichtempfindlichen, photopolymerisierbaren Aufzeichnungsmaterialien für die Herstellung von Relief- und Druckformen sind im allgemeinen negativ arbeitend, d. h. bei einer bildmäßigen Belichtung der photopolymerisierbaren Schicht werden die belichteten Bereiche dieser Schicht photopolymerisiert und in Lösungsmitteln unlöslich, in denen sie vorher löslich waren, während die durch die Kopiervorlage abgedeckten, unbelichteten Bereiche der Schicht löslich bleiben und beim Entwickeln der Relief- und Druckform entfernt werden.

Diese photopolymerisierbaren Aufzeichnungsmaterialien benötigen im allgemeinen relativ lange Belichtungszeiten, weshalb sie nicht mit einer Reprokamera in vernünftigen Zeiten belichtet werden können. Ferner sind sie mit den gebräuchlichen Laser-Belichtern nicht kompatibel und somit für diese modernen Belichtungsmethoden nicht zugänglich. Darüber hinaus ist es häufig erwünscht, eine Relief- oder Druckform herzustellen, die eine positive Kopie des Originals darstellt. Zur Herstellung von positiven Bildern muß bei den negativ arbeitenden Aufzeichnungsmaterialien immer über einen Zwischenfilm gearbeitet werden. Dies bedeutet eine wesentliche Einschränkung, denn Negativ-Vorlagen sind nicht immer zweckmäßig.

Es sind auch bereits Verfahren bekannt, die es gestatten, mit lichtempfindlichen, photopolymerisierbaren Schichten positive Abbilder der bildmäßigen Vorlagen herzustellen. Unter positiv arbeitenden Aufzeichnungsmaterialien bzw. positiv arbeitenden Bildherstellungs-Verfahren werden dabei im weiteren solche verstanden, bei denen die Bereiche der lichtempfindlichen Schicht, die den dunklen oder opaken Bereichen des Originals entsprechen, photopolymerisiert werden, während die den hellen oder transparenten Bereichen des Originals entsprechenden Bereiche der lichtempfindlichen Schicht im wesentlichen unpolymerisiert bleiben und beim Entwickeln des Bildreliefs unter Zurücklassung der photopolymerisierten Bereiche entfernt werden.

Bei dem in der US-PS 3 380 825 beschriebenen Verfahren wird beispielsweise die photopolymerisierbare Schicht einer ersten bildmäßigen Belichtung unter solchen Bedingungen unterworfen, daß ein gasförmiger Polymerisationsinhibitor den Photoinitiator, der durch aktinisches Licht in den belichteten Bereichen angeregt worden ist, ausschaltet, ohne daß eine nennenswerte Polymerisation aufgetreten ist. Die lichtempfindliche Schicht wird dann gegen den gasförmigen Inhibitor während einer zweiten, nicht bildmäßigen Belichtung mit dem gleichen aktinischen Licht abgeschirmt, wobei eine Photopolymerisation lediglich in jenen Bereichen erfolgt, in denen der Photoinitiator bei der ersten bildmäßigen Belichtung nicht aufgebraucht worden ist. Dieses Verfahren erfordert jedoch nicht nur ein sehr sorgfältiges Arbeiten, um die gewünschte Photopolymerisation bei der zweiten Belichtung sicherzustellen, sondern ist auch wegen der erforderlichen Behandlungsmaßnahmen in der Praxis schwer durchzuführen.

In der DE-B2-2 338 223 wird ein Verfahren zur Herstellung positiver Bilder beschrieben, bei dem man eine photopolymerisierbare Schicht, die einen Wasserstoffdonator, ein Hexaarylbisimidazol, eine ethylenisch ungesättigte radikalisch polymerisierbare Verbindung sowie ein polymeres Bindemittel in bestimmten Mengenverhältnissen enthält, zuerst mit einer Strahlung hoher Intensität bildmäßig belichtet und dabei die Fähigkeit zur Photopolymerisation in den belichteten Bereichen der Schicht zerstört und anschließend die gesamte Schicht einer Belichtung mit einer Strahlung niederer Intensität unterwirft, wodurch die Photopolymerisation in den vorher unbelichteten Bereichen eingeleitet wird. Nachteilig bei diesem Verfahren ist, daß sowohl die erste, bildmäßige Belichtung als auch die zweite vollflächige Belichtung der photopolymerisierbaren Schicht mit aktinischem Licht der gleichen Wellenlänge vorgenommen wird und es somit einer sehr genauen und sorgfältigen Kontrolle der Lichtintensität bedarf, um die notwendige und angestrebte Differenzierung in der Schicht durch die Photopolymerisation zu erzielen. Auch sind bei diesem Verfahren, wie sich aus den Beispielen der DE-B2-23 38 223 ergibt, die notwendigen Gesamtbelichtungszeiten für die Praxis zu hoch.

In der DE-A1-27 10 417 sowie der US-PS 3 556 794 werden Verfahren zur Herstellung von positiven Bildern beschrieben, bei denen man eine photopolymerisierbare Schicht, die mindestens eine photopolymerisierbare Verbindung, ein lichtaktivierbares Initiatorsystem sowie eine nitroaromatische Verbindung enthält, zunächst bildmäßig mit kurzwelligem Licht einer Wellenlänge im Bereich von 200 bis etwa 400 nm belichtet, wobei aus der nitroaromatischen Verbindung ein Polymerisationsinhibitor gebildet wird, und anschließend die Schicht mit längerwelligem Licht einer Wellenlänge größer 400 nm belichtet, wodurch in den während der ersten bildmäßigen Belichtung nicht belichteten Bereichen der Schicht eine Photopolymerisation ausgelöst wird. Während in der DE-A1-27 10 417 als lichtaktivierbare Initiatorsysteme beispielsweise Verbindungen wie Derivate von Benzophenon, Phenanthrenchinon oder Imidazoldimeren, genannt werden, soll gemäß der US-PS 3 556 794 als Photoinitiator-System eine Kombination aus einem Farbstoff und einem Reduktionsmittel oder einem Katalysator, der zur Erzeugung freier Radikale fähig ist, eingesetzt werden.

In der US-PS 3 556 794 wird dabei insbesondere die Herstellung von sichtbaren, positiven Bildern beschrieben ; die Herstellung von Relief- und insbesondere Druckformen ist hierin nicht erwähnt. Gemäß den in der DE-A1-27 10 417 und der US-PS 3 556 794 beschriebenen Verfahren wird die Polymerisation durch Bestrahlen der photopolymerisierbaren Gemische mit sichtbarem Licht ausgelöst. Für die Herstellung von Relief- und/oder Druckformen ist die Photopolymerisation mit sichtbarem Licht im allgemeinen jedoch wenig vorteilhaft, da hierbei die Lichtausbeute unbefriedigend ist ; demzufolge ist hierbei das Ausmaß der Polymerisation häufig für die Herstellung von Relief- und/oder Druckformen unzureichend. Es ist daher sinnvoll und in der Praxis auch üblich, lichtempfindliche, photopolymerisierbare Aufzeichnungsmaterialien für die Herstellung von Relief- und/oder Druckformen durch Belichtung mit UV-Licht zu polymerisieren.

Der vorliegenden Erfindung lag die Aufgabe zugrunde, ausgehend von lichtempfindlichen, photopolymerisierbaren Schichten, ein positiv arbeitendes Verfahren zur Herstellung von Relief- und/oder Druckformen aufzuzeigen, bei welchem die Photopolymerisation in der Schicht durch Bestrahlen mit Licht im UV-Wellenlängenbereich ausgelöst werden kann, welches dabei den Einsatz von üblichen Lasern für die Belichtung zuläßt und sehr kurze Belichtungszeiten gestattet. Das Verfahren soll einfach und leicht durchführbar sein und zu exakten und vorlagengetreuen Relief- und/oder Druckformen mit gut ausgebildeter Reliefstrucktur führen.

Es wurde nun überraschend gefunden, daß man Relief- und/oder Druckformen, die ein positives Abbild einer bildmäßigen Vorlage darstellen und die gewünschten Eigenschaften besitzen, schnell und einfach herstellen kann, indem man eine photopolymerisierbare Schicht, die mindestens eine photopolymerisierbare Verbindung, mindestens einen mit UV-Licht aktivierbaren Photopolymerisationsinitiator sowie eine Kombination aus einem speziellen Farbstoff und einem Reduktionsmittel für diesen Farbstoff im angeregten Elektronenzustand enthält, bildmäßig mit längerwelligem, insbesondere sichtbarem Licht unter Erzeugung einer Verbindung, die die Photopolymerisation in der Schicht inhibiert, belichtet, die Schicht gleichzeitig oder anschließend vollflächig mit UV-Licht bestrahlt, wodurch die nicht mit dem längerwelligen Licht belichteten Bereiche der Schicht polymerisiert werden, und danach die nichtpolymerisierten Bereiche der Schicht unter Entwicklung der Relief- und/oder Druckform entfernt.

Gegenstand der Erfindung ist demzufolge ein positiv arbeitendes Verfahren zur Herstellung von Relief- und/oder

Druckformen, bei dem man eine photopolymerisierbare Schicht, enthaltend

a) mindestens eine Verbindung mit mindestens einer photopolymerisierbaren olefinisch ungesättigten Doppelbindung,

b) mindestens einen Photoinitiator, der bei der Belichtung mit Licht im Wellenlängenbereich von 300 bis 420 nm eine rasche Photopolymerisation in der Schicht auslöst, sowie

c) weitere Zusatzstoffe,

bildmäßig belichtet, wodurch in den belichteten Bereichen die Polymerisationsfähigkeit unterdrückt wird ; durch eine weitere Belichtung mit Licht im Wellenlängenbereich von 300 bis 420 nm die zunächst nicht belichteten, noch photopolymerisierbaren Bereiche der Schicht polymerisiert ; und anschließend die Relief- und/oder Druckform durch Entfernen, insbesondere Auswaschen, der nichtpolymerisierten Bereiche der Schicht entwickelt. Das Verfahren ist dadurch gekennzeichnet, daß die Schicht eine Kombination enthält von

c) 1. 0,000 1 bis 1 Gew.-%, bezogen auf die Summe aller Bestandteile der Schicht, eines löslichen Farbstoffs der Formel (I)

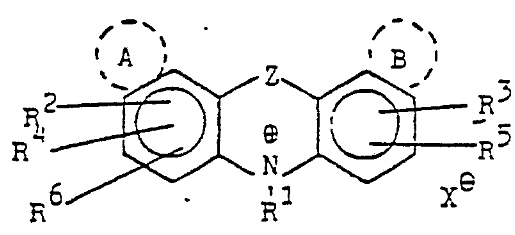

(I)

worin bedeuten

Z : N, O, S oder $CR^7$ ;

$R^1$ : ein Wasserstoffatom, $C_1$-$C_4$-Alkyl, ggf. substituiertes Phenyl oder Naphthyl ;

$R^2$, $R^3$ : gleiche oder verschiedene Reste aus der Gruppe Wasserstoffatom, Hydroxy, $C_1$-$C_4$-Alkoxy, Phenoxy, ggf. substituiertes Diarylmethyl und $NR_2$ [mit R = H, ggf. substituierten Alkyl-, Aryl- oder Aralkylresten, wobei die beiden Reste R gleich oder verschieden sein können] ;

$R^4$, $R^5$ : gleiche oder verschiedene Reste aus der Gruppe Wasserstoffatom, $C_1$-$C_4$-Alkyl-, Phenyl-, Hydroxy-, $C_1$-$C_4$-Alkoxy-, Sulfo- oder $NR_2$-Gruppe [mit R = H, ggf. substituierten Acyl-, Alkyl-, Aryl- oder Aralkylresten, wobei die beiden Reste R gleich oder verschieden sein können] ;

$R^6$: ein Wasserstoffatom, eine Hydroxy-, $C_1$-$C_4$-Alkoxy-, Carboxyl-, Carbalkoxy-, N-Acylamino-Gruppe oder ein Halogenatom ;

$R^7$ : ein Wasserstoffatom, $C_1$-$C_4$-Alkyl oder ggf. substituiertes Aryl oder Aralkyl ;

$X^{\ominus}$ : ein Säureanion ;

A, B : entweder Wasserstoffatome oder ein ankondensiertes Benzo-, Naphtho- oder Heterocyclensystem mit Ankondensation in a-, a- oder c-Stellung mit der Maßgabe, daß im Fall A = ein ankondensiertes Ringsystem der genannten Art einer der Reste $R^2$ oder $R^4$ entfällt, wobei die Reste A und B gleich oder verschieden sein können ; und

c) 2. einer hinreichenden Menge eines milden Reduktionsmittels für den Farbstoff (c1), das den Farbstoff (c1) in Abwesenheit von aktinischem Licht nicht reduziert, den durch Belichtung mit Licht einer Wellenlänge größer als 450 nm, insbesondere sichtbarem Licht, in den angeregten Elektronenzustand versetzten Farbstoff (c1) jedoch reduzieren kann ; daß man das bildmäßige Belichten der Schicht mit Licht einer Wellenlänge größer als 450 nm, insbesondere im Wellenlängenbereich des sichtbaren Lichts, durchführt, wodurch in der Schicht unter Reduktion des Farbstoffs (c1) bildmäßig eine Verbindung erzeugt wird, die eine Photopolymerisation in der Schicht bei Aktivierung des Photoinitiators (b) inhibiert bzw. den Photoinitiator (b) inaktiviert ; und daß die weitere Belichtung der Schicht gleichzeitig oder anschließend vollflächig erfolgt, wodurch die nicht mit dem längerwelligen Licht belichteten Bereiche der Schicht polymerisiert werden.

Gegenstand der Erfindung sind weiterhin spezielle Ausgestaltungsformen des erfindungsgemäßen Verfahrens entsprechend der nachfolgenden detaillierten Beschreibung.

Es war äußerst überraschend, daß in photopolymerisierbaren Schichten, die neben mindestens einer photopolymerisierbaren Verbindung und mindestens einem durch Licht im Wellenlängenbereich von 300 bis 420 nm aktivierbaren Photoinitiator einen Zusatz der genannten Farbstoffe und Reduktionsmittel enthalten, durch Belichtung mit längerwelligem, insbesondere sichtbarem Licht die Polymerisationsfähigkeit der Schicht derart unterdrückt bzw. inhibiert werden kann, daß bei Belichtung der Schicht mit UV-Licht (300-420 nm) keine nennenswerte Polymerisation mehr stattfindet, so daß die derartig belichteten Schichtanteile bei der nachfolgenden Entwicklung der Relief- und/oder Druckformen ohne Schwierigkeiten entfernt bzw. ausgewaschen werden können. Auch wenn beispielsweise in der DE-A1-29 31 553 die stabilisierende Wirkung einer Mischung von Phenothiazin und p-Nitrosophenol für monomere Acrylsäureester beschrieben wird und einige der Farbstoffe der Formel (I), wie z. B. Methylenblau, als thermische Polymerisationsinhibitoren für photopolymerisierbare Mischungen bekannt sind (vgl. z. B. DE-OS 22 15 090), war es doch in keiner Weise vorhersehbar, daß der Zusatz der genannten Kombination aus einem Farbstoff der Formel (I) und dem Reduktionsmittel die Photopolymerisation in den mit UV-Licht photopolymerisierbaren Schichten weitgehend oder vollständig verhindern kann, insbesondere nachdem u. a. in der US-PS 3 556 794, der US-PS 3 097 097 und in J.A.C.S., Vol. 79 (1957), Seiten 595 bis 598 derartige Mischungen aus den genannten Farbstoffen und Reduktionsmitteln als Initiator-Systeme für die Photopolymerisation insbesondere von Acryl-Monomeren beschrieben werden. Es stand auch nicht zu erwarten, daß es mit dem erfindungsgemäßen Verfahren möglich ist, vergleichsweise sehr kurze Belichtungszeiten für die Photopolymerisation einzuhalten und dabei eine hinreichende und gute Differenzierung zwischen den polymerisierten und nichtpolymerisierten Bereichen der Schicht zu erzielen, wie es für die Herstellung von Relief- und/oder Druckformen notwendig ist. Das erfindungsgemäße Verfahren führt zu exakten und vorlagegetreuen Relief- und/oder Druckformen mit guten, teilweise verbesserten Eigenschaften, insbesondere mit sehr gut ausgebildeten Reliefstrukturen.

Besonders vorteilhaft in dem erfindungsgemäßen Verfahren ist auch eine äußerst schnelle, die Verarbeitung der photopolymerisierbaren Schicht aber in keiner Weise negativ beeinflussende Veränderung der Absorptionseigenschaften der Farbstoffzusätze während der bildmäßigen Belichtung. Dabei können je nach Farbstoffwahl innerhalb der vorgegebenen Farbstoffstrukturen die unterschiedlichsten gewünschten Effekte eingestellt werden, von einer totalen Ausbleichung der Farbstoffe bis zu einer Farbtonverschiebung von z. B. blau nach rot. Diese Eigenschaft der erfindungsgemäß zu verwendenden Schichten erleichtert in dem erfindungsgemäßen Verfahren zur Herstellung von Relief- und/oder Druckformen erheblich die Beurteilung der belichteten Formen. Praktisch werden daher solche Farbstoffe als Zusätze bevorzugt, die eine visuelle Beurteilung der belichteten Form am günstigsten gestalten.

Es hat sich gezeigt, daß sich für das erfindungsgemäße Verfahren nur die Farbstoffe der durch die Formel (I) wiedergegebenen Klasse eignen. Strukturell ähnlich aufgebaute Farbstoffe, wie beispielsweise die Di- oder Triphenylmethanfarbstoffe oder die Xanthenfarbstoffe, die auch häufig in photopolymerisierbaren Schichten eingesetzt werden, geben die Effekte der erfindungsgemäß zu verwendenden Farbstoffe der Formel (I) nicht und können daher nicht in dem erfindungsgemäßen Verfahren als Komponente (c1) eingesetzt werden.

Die in dem erfindungsgemäßen Verfahren einzusetzenden Schichten enthalten als wesentlichen Bestandteil a) eine oder mehrere Verbindungen mit mindestens einer photopolymerisierbaren, olefinisch ungesättigten Doppelbindung. Hierbei lassen sich die bekannten, für die Herstellung von Reliefformen und photopolymeren Hoch-, Tief- und Offset-Druckplatten üblicherweise verwendeten Monomeren, Oligomeren und/oder ungesättigten Polymeren verwenden, deren Art sich nach dem Verwendungszweck der photopolymerisierbaren Schicht, aber auch nach der Art der anderen Mischungskomponenten und,

bei der bevorzugten Mitverwendung von polymeren Bindemitteln in der Mischung der Schicht, nach der Art und Verträglichkeit mit diesen richtet. Bevorzugt sind Monomere und/oder Oligomere mit 2 oder mehr olefinisch ungesättigten photopolymerisierbaren Doppelbindungen allein oder in Mischung mit Monomeren mit nur einer olefinisch ungesättigten, photopolymerisierbaren Doppelbindung. Auch Polymere mit mehreren seiten- und/oder endständigen olefinisch ungesättigten Doppelbindungen sind als alleinige photopolymerisierbare Verbindung oder in Mischung mit den Monomeren und/oder Oligomeren verwendbar. Beispiele für geeignete Monomeren sind die Di- und Polyacrylate und -methacrylate, wie sie durch Veresterung von Diolen oder Polyolen mit Acrylsäure oder Methacrylsäure hergestellt werden können. Hierzu gehören die Di- und Tri-(meth)acrylate von Ethylenglykol, Diethylenglykol, Triethylenglykol oder Polyethylenglykolen mit einem Molekulargewicht bis etwa 500, 1,2-Propandiol, 1,3-Propandiol, Neopentylglykol (2,2-Dimethylpropandiol), 1,4-Butandiol, 1,1,1-Trimethylolpropan, Glycerin oder Pentaerythrit; ferner die Monoacrylate und Monomethacrylate solcher Diole und Polyole, wie z. B. Ethylenglykol-, Di-, Tri- oder Tetraethylenglykolmono(meth)acrylat; Monomere mit zwei- oder mehr olefinisch ungesättigten Bindungen, die Urethangruppen und/oder Amidgruppen enthalten, wie die aus aliphatischen Diolen der vorstehend genannten Art, organischen Diisocyanaten und Hydroxyalkyl(meth)acrylaten hergestellten niedermolekularen Verbindungen. Genannt seien auch Acrylsäure, Methacrylsäure sowie deren Derivate wie (Meth)acrylamid, N-Hydroxymethyl(meth)acrylamid oder die (Meth)acrylate von Monoalkoholen mit 1 bis 6 C-Atomen.

Bevorzugt enthalten die in dem erfindungsgemäßen Verfahren einzusetzenden Schichten auch ein oder mehrere polymere Bindemittel. Als solche kommen hierbei die für die photopolymerisierbaren Mischungen für die Herstellung von Relief- und Druckformen an sich bekannten und üblichen organischen polymeren Bindemittel in Betracht, wobei diese Bindemittel mit den mitverwendeten photopolymerisierbaren, olefinisch ungesättigten Verbindungen (a) verträglich und — für den Fachmann selbstverständlich — in den Entwicklerlösungsmitteln löslich oder dispergierbar sein sollen, um ein Auswaschen der unvernetzten Anteile der Schicht nach der Belichtung zu ermöglichen. Als geeignete polymere, olefinisch gesättigte oder ungesättigte Bindemittel seien genannt: ungesättigte Polyester, lineare Polyamide und besonders alkohollösliche Copolyamide, wie sie in der FR-PS 1 520 856 beschrieben sind, Cellulosederivate, insbesondere wäßrig-alkalisch auswaschbare Cellulosederivate, Vinylalkohol-Polymere sowie Polymere und Copolymere von Vinylestern aliphatischer Monocarbonsäuren mit 1 bis 4 C-Atomen, wie von Vinylacetat, mit unterschiedlichem Verseifungsgrad, Polyurethane wie Polyetherurethane und Polyesterurethane, Polyacrylsäure- und Polymethacrylsäureester, Styrol/Butadien-, Styrol/Isopren- oder Styrol/Butadien/Isopren-Copolymere, Styrol/Maleinsäureanhydrid- oder Styrol/Maleinsäure(halb)-ester-Copolymerisate, Styrol/Maleinsäureanhydrid/(Meth)acrylsäure-Copolymerisate, modifizierte Polyvinylalkoholderivate, wie z. B. Polyvinylbutyral oder das in der DE-OS-30 15 340 erwähnte Umsetzungsprodukt eines Polyvinylalkohols mit einem gewissen Teil von (Meth)acrylsäureanhydrid. Als polymere Bindemittel sind für die Herstellung von Reliefdruckformen für den Flexodruck auch elastomere Dien-Polymere und -Copolymere, beispielsweise von Butadien und/oder Isopren, geeignet, von denen die Blockcopolymeren, die Polybutadien- und/oder Polyisopren-Blöcke und Polymerblöcke aus Styrol und/oder α-Methylstyrol enthalten, besonders bevorzugt sind. Des weiteren eignen sich auch die Nitrilkautschuke, wie z. B. die Butadien/Acrylnitril-Copolymerisate.

Sofern in der photopolymerisierbaren Schicht polymere Bindemittel enthalten sind, beträgt ihr Anteil im allgemeinen etwa 5 bis 90 Gew.-%, insbesondere 45 bis 80 Gew.-%, bezogen auf die Summe von polymerem Bindemittel und photopolymerisierbarer Verbindung. Der Gehalt an polymerem Bindemittel richtet sich insbesondere auch nach der Verwendung der photopolymerisierbaren Schicht. Welche photopolymerisierbaren, olefinisch ungesättigten Monomeren, Oligomeren und/oder Polymeren vorteilhaft mit welchen polymeren Bindemitteln kombiniert werden können, kann der einschlägigen Patentliteratur entnommen werden.

Die in dem erfindungsgemäßen Verfahren einzusetzenden photopolymerisierbaren Schichten enthalten mindestens einen Photoinitiator (b), der — in an sich bekannter Weise — bei Belichtung der Schicht mit Licht im Wellenlängenbereich von 300 bis 420 nm eine rasche Photopolymerisation in der Schicht auslöst. Der Photoinitiator (b) ist in der photopolymerisierbaren Schicht im allgemeinen in Mengen von 0,01 bis 10 Gew.-%, bevorzugt von 0,01 bis 3 Gew.-%, bezogen auf die Summe aller Bestandteile der photopolymerisierbaren Schicht, enthalten. Als Photoinitiatoren (b) kommen z. B. Acyloine und Acyloinether sowie aromatische Diketone und deren Derivate in Frage. Sehr geeignet sind beispielsweise Benzoin und α-Hydroxymethyl-benzoin, sowie deren Alkylether mit 1 bis 8 C-Atomen, wie Benzoin-isopropylether, α-Hydroxymethyl-benzoinmethylether oder Benzoinmethylether; Benzilmonoketale, wie Benzil-dimethylketal, Benzil-methyl-ethylketal, Benzil-methyl-benzylketal oder Benzil-neopentylketal; oder Diarylphosphinoxide, wie sie in der DE-OS 29 09 992 beschrieben sind, beispielsweise 2,6-Dimethoxy-benzoyldiphenylphosphinoxid oder 2,4,6-Trimethylbenzoyl-diphenylphosphinoxid. Bevorzugt werden die Photoinitiatoren (b) nach Art und Menge so gewählt, daß für die Auslösung der Photopolymerisation bei der Belichtung der photopolymerisierbaren Schicht mit Licht im Wellenlängenbereich von 300 bis 420 nm, vorzugsweise im Wellenlängenbereich von 320 bis 380 nm, nur kurze Mindestbelichtungszeiten benötigt werden. Die Photoinitiatoren (b) sind bevorzugt keine Farbstoffe.

Die in dem erfindungsgemäßen Verfahren einzusetzenden photopolymerisierbaren Schichten enthalten neben den Komponenten (a) und (b) als wesentlichen Bestandteil eine Mischung bestimmter

Farbstoffe (c1) mit milden Reduktionsmitteln (c2) für den mitverwendeten jeweiligen Farbstoff (c1). Es hat sich dabei überraschenderweise gezeigt, daß die Mischung (c1) + (c2) in der photopolymerisierbaren Schicht bei der Belichtung mit aktinischem Licht keine merkliche Photopolymerisation auslöst, sondern im Gegenteil bei Bestrahlung der Schicht mit Licht einer Wellenlänge größer als 450 nm, insbesondere mit sichtbarem Licht, eine Verbindung erzeugt wird, die eine durch den Photoinitiator (b) ausgelöste Photopolymerisation in der Schicht so weitgehend und vollständig inhibiert bzw. verhindert, daß die derart belichteten Schichtanteile problemlos mit einer Entwicklerflüssigkeit unter Ausbildung einer ausgezeichneten Reliefstruktur ausgewaschen werden können. Geeignete Kombinationen von Farbstoff (c1) und mildem Reduktionsmittel (c2) lassen sich mit einfachen, wenigen Vorversuchen leicht feststellen.

Als Farbstoffe (c1) der angegebenen Formel (I) eignen sich mit besonderem Vorteil solche aus der Reihe der Thiaziniumfarbstoffe der Formel (II)

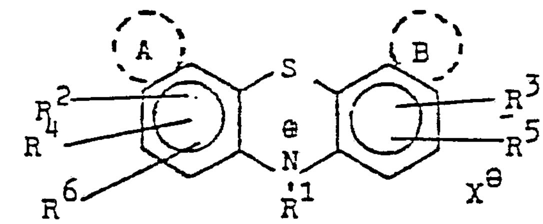

(II)

wobei $X^{\ominus}$, A, B sowie die Reste $R^1$ bis $R^6$ die oben angegebenen Bedeutungen haben. Als Beispiel sehr geeigneter Farbstoffe dieser Klasse seien genannt : Methylenblau (C.I. 52 015) und Thionin (C.I. 52 025).

Des weiteren eignen sich in vorteilhafter Weise als Farbstoffe solche aus der Reihe der Phenoxaziniumfarbstoffe der Formel (III) :

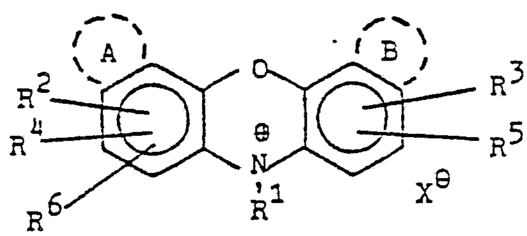

(III)

wobei $X^{\ominus}$, A, B sowie $R^1$ bis $R^6$ die angegebenen Bedeutungen haben. Als Beispiele sehr geeigneter Farbstoffe dieser Klasse seien genannt: Capriblau GN (C.I. 51 000), Zaponechtblau 3 G (C.I. 51 005), Galloblau E (C.I. 51 040), Echtneublau 3 G (C.I. 51 175), Nilblau A (C.I. 51 180), Echtgrün M (C.I. 51 210), Echtschwarz L (C.I. 51 215) sowie Rhodanilblau, dem Salz bzw. Amid aus Rhodamin B (Basic Violet 10, C.I. 45 170) und Nilblau (Basic Blue 12, C.I. 51 180).

Besonders bevorzugt sind auch Verbindungen aus der Reihe der Phenaziniumfarbstoffe der Formel (IV) :

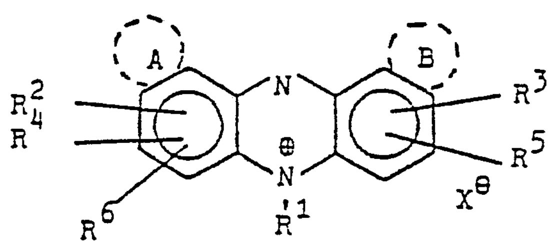

(IV)

wobei $X^{\ominus}$, A, B sowie $R^1$ bis $R^6$ die oben angeführten Bedeutungen haben. Als Beispiele sehr geeigneter Farbstoffe dieser Klasse seien hier genannt: Neutralrot (C.I. 50 040), Neutralviolett (C.I. 50 030), Azinscharlach G (C.I. 50 045), Rhodulinheliotrop 3 B (C.I. 50 055), Neutralblau C (C.I. 50 150), Azingrün GB (C.I. 50 155), Safranin B (C.I. 50 200), Indaminblau B (C.I. 50 204), Rhodulinrot G (C.I. 50 215), Rhodulinblau GG extra (C.I. 50 220), Indazin GB (C.I. 50 221), Safranin T (C.I. 50 240), Mauvein (C.I. 50 245), Naphthylrot (C.I. 50 370) sowie Nigrosinschwarz T (C.I. 50 415).

Genannt seien ferner die Acridiniumfarbstoffe der Formel (V)

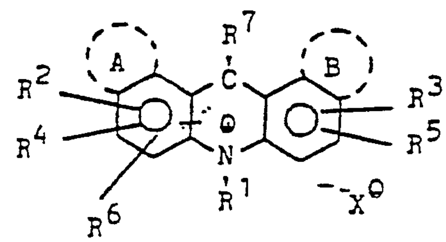

(V)

wobei $X^{\ominus}$, A, B, $R^1$ bis $R^7$ die oben angeführten Bedeutungen haben, von denen als geeignete Farbstoffe angeführt seien: Acriflavin (C.I. 46 000), Acridinorange (C.I. 46 005), Acridinscharlach J (C.I. 46 015), Acridingelb G (C.I. 46 025), Aurazin G (C.I. 46 030), Diamantphosphin GG (C.I. 46 035), Phosphin E (C.I. 46 045), Flaveosin (C.I. 46 060), Benzoflavin (C.I. 46 065) und Rheonin A (C.I. 46 075).

Zum besseren Verständnis der Formeln (I) bis (V) seien die nachstehenden Beispiele für die Reste $R^1$ bis $R^7$, A, B und $X^{\ominus}$ geeigneter Farbstoffe angeführt:

Beispiele für den Rest $R^1$ sind Wasserstoff, Methyl, Ethyl, Phenyl, 2-Methoxyphenyl, 4-Methylphenyl, 2,4-Dimethylphenyl, 2-Methylphenyl, 4-Sulfophenyl, 2-Methyl-3-sulfophenyl, 1-Naphthyl, 2-Naphthyl, 5,8-Disulfo-2-naphthyl. Beispiele für die Reste $R^2$ und $R^3$ sind Wasserstoff, Hydroxy, Methoxy, Di(p-diethylamino-phenyl)methyl, Amino, N-Methylamino, N-Ethylamino, Dimethylamino, Diethylamino, N-Phenylamino, N-(4-Sulfophenyl)-amino, N-(2,4-Disulfophenyl)amino, N-(2-sulfo-4-amino-phenyl)amino, N-(2-Methylphenyl)amino, N-(3-Methoxyphenyl)amino, N(4-Diethylaminophenyl)amino, N-(4-Dimethylaminophenyl)amino, N-(2-Sulfo-4-methylamino-5-methylphenyl)amino, N-(5,8-Disulfonaphthyl)amino, N-Ethyl-N-benzylamino, Phenaziniumylamino, Oxaziniumylamino oder Rhodaminylamino. Beispiele für die Reste $R^4$ und $R^5$ sind Wasserstoff, Methyl, Methoxy, Sulfo, N-Methylamino, N-Ethylamino, Dimethylamino, Diethylamino, N-Phenylamino und N(4-Diethylaminophenyl)amino. Beispiele für den Rest $R^6$ sind Wasserstoff, Hydroxy, Methoxy, Chloro, Bromo, .Carboxyl, Carbmethoxy oder N-Acetylamino, Beispiele für den Rest $R^7$ sind Wasserstoff, Methyl, Ethyl, Phenyl, 4-Aminophenyl oder 2-Carboxyphenyl.

Beispiele für das Säureanion sind $Cl^{\ominus}$, $Br^{\ominus}$, $ClO_4^{\ominus}$, $HSO_4^{\ominus}$, $CH_3SO_4^{\ominus}$ und ähnliche bekannte, insbesondere einwertige anorganische und organische Säureanionen. Sehr geeignete Salze sind oft die Chlorhydrate. Beispiele für die Reste A und B sind Wasserstoff, Benz [a], Dibenz [a, c], Dibenz [a, f], Dibenz [a, d], Tetrabenz [a,c,d,f], ggf. substituiert,

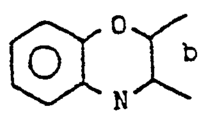

,

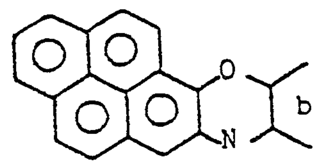

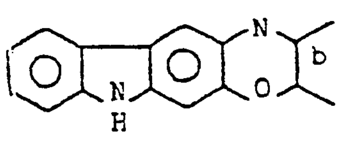

und

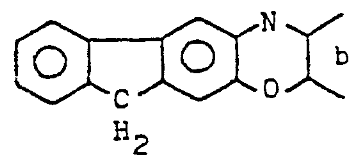

Bevorzugte Farbstoffe (c1) für die photopolymerisierbare Schicht sind wegen ihrer guten Wirkung, aber auch wegen ihres ästhetischen Eindrucks und einer einfachen visuellen Beurteilung der Relief- und/oder Druckformen, Neutralrot (C.I. 50 040), Safranin T (C.I. 50 240) sowie insbesondere auch Methylenblau (C.I. 52 015) und Thionin (C.I. 52 025).

Die erfindungsgemäß zu verwendenden, photopolymerisierbaren Schichten enthalten in Kombination mit dem Farbstoff (c1) eine hinreichende Menge eines milden Reduktionsmittels für den Farbstoff (c1), das den mitverwendeten Farbstoff (c1) in Abwesenheit von aktinischem Licht nicht reduziert, den durch Belichtung mit Licht einer Wellenlänge größer als 450 nm, insbesondere sichtbarem Licht, in den angeregten Elektronenzustand versetzten Farbstoff (c1) jedoch zu reduzieren vermag, insbesondere zum Semichinon. Beispiele solcher milden Reduktionsmittel sind Ascorbinsäure, Anethol, Thioharnstoff, Diethylallylthioharnstoff, Hydroxylamin-derivate, insbesondere N-Allylthioharnstoff und bevorzugt Salze des N-Nitrosocyclohexyl-hydroxylamins, insbesondere die Kalium- und/oder Aluminiumsalze. Letztere sind auch als Inhibitoren gegen die thermische Polymerisation in photopolymerisierbaren Mischungen bekannt. Die Menge der in der photopolymerisierbaren Schicht enthaltenen milden Reduktionsmittel (c2) beträgt im allgemeinen etwa 0,005 bis 5 Gew.-%, insbesondere 0,01 bis 1 Gew.-%, bezogen auf die Summe aller Bestandteile der photopolymerisierbaren Schicht. In vielen Fällen hat sich der Zusatz des 3- bis 10-fachen der Menge (Gewichtsverhältnis) an mitverwendetem Farbstoff (c1) bewährt.

Neben den genannten Bestandteilen können die erfindungsgemäß einzusetzenden photopolymerisierbaren Schichten in bekannter Weise natürlich auch noch weitere, für photopolymerisierbare

Schichten übliche Zusatzstoffe enthalten. Hierzu gehören insbesondere die Inhibitoren gegen thermische Polymerisation, wie z. B. Hydrochinon, p-Methoxyphenol, Dinitrobenzol, p-Chinon, Methylenblau, β-Naphthol, N-Nitrosamine wie N-Nitrosodiphenylamin, Phosphorigsäureester wie Triphenylphosphit, oder die Salze, insbesondere die Alkali- und Aluminiumsalze, des N-Nitroso-cyclohexyl-hydroxylamins. Die thermischen Polymerisationsinhibitoren sind in der photopolymerisierbaren Schicht im allgemeinen in einer Menge von 0,001 bis 3 Gew.-% und insbesondere in einer Menge von 0,003 bis 1 Gew.-%, bezogen auf die Summe aller Bestandteile der photopolymerisierbaren Schicht, enthalten. Wie bereits weiter oben erwähnt, ist es dabei durchaus möglich, daß die als Komponente (c1) enthaltenen Farbstoffe und/oder die als Komponente (c2) enthaltenen Reduktionsmittel gleichzeitig als thermische Polymerisationsinhibitoren in der Schicht wirken, wie es beispielsweise für Methylenblau oder die Salze des N-Nitroso-cyclohexylhydroxylamin der Fall ist. Es hat sich gezeigt, daß solche als thermische Polymerisationsinhibitoren bekannten Verbindungen sehr wohl erfindungsgemäß eingesetzt werden können, um bei Belichtung der photopolymerisierbaren Schicht mit Licht einer Wellenlänge größer als 450 nm eine Verbindung zu erzeugen, die die durch den Photoinitiator (b) initiierte Photopolymerisation verhindert, während diese Verbindungen in den Bereichen der Schicht, die nicht mit Licht einer Wellenlänge größer als 450 nm bestrahlt worden sind, zwar die thermisch induzierte Polymerisation inhibieren, nicht aber die durch den Photoinitiator (b) ausgelöste Photopolymerisation nachteilig beeinflussen oder beeinträchtigen. Gleichwohl ist darauf zu achten, daß in den Fällen, in denen der Farbstoff (c1) und/oder das milde Reduktionsmittel (c2) auch als thermische Polymerisationsinhibitoren wirken, deren Mengen in der Schicht so gewählt werden, daß die für die thermischen Polymerisationsinhibitoren üblichen und gebräuchlichen Mengen nicht überschritten werden.

Als weitere Zusatzstoffe können die in dem erfindungsgemäßen Verfahren einzusetzenden photopolymerisierbaren Schichten beispielsweise die hierfür üblichen und gebräuchlichen Weichmacher, gesättigten niedermolekularen Verbindungen mit Amid- oder Alkoholgruppen, Wachse, Pigmente etc. enthalten. Sehr vorteilhafte Schichten für die Herstellung von photopolymeren Tiefdruckformen enthalten beispielsweise feinteilige, harte Füllstoffe, wie Quarzmehl.

Die photopolymerisierbaren Schichten können nach den bekannten und üblichen Verfahren hergestellt werden, beispielsweise durch Gießen der Schicht aus einer Lösung der Bestandteile und Verdampfen des Lösungsmittels. Die in dem erfindungsgemäßen Verfahren einzusetzenden photopolymerisierbaren Schichten sind im wesentlichen lösungsmittelfrei und können — in Abhängigkeit von der Art der verwendeten Bestandteile — flüssig sein, vorzugsweise werden jedoch feste photopolymerisierbare Schichten eingesetzt. Die Dicke der photopolymerisierbaren Schicht kann in weiten Grenzen variiert werden und wird in erster Linie von dem Anwendungszweck der hergestellten Relief- und/oder Druckformen bestimmt. Für die Herstellung von photopolymeren Hochdruckformen liegt die Dicke der photopolymerisierbaren Schicht im allgemeinen im Bereich von 200 bis 1 000 µm ; für die Herstellung von Tiefdruckformen werden vorteilhafterweise Schichten mit einer Dicke im Bereich von etwa 50 bis 500 µm eingesetzt ; für die Herstellung von Reisistmustern, Offsetdruckplatten oder auch Maskenfilmen können auch dünnere Schichten Anwendung finden. Im allgemeinen wird die lichtempfindliche, photopolymerisierbare Schicht für die Herstellung der Relief- und/oder Druckformen auf einem dimensionsstabilen Träger aufgebracht sein. Als Träger kommen vor allem die üblichen metallischen Unterlagen, wie z. B. Stahl- oder Aluminiumbleche für die Herstellung von Druckformen oder beispielsweise Kupferbleche oder kupferbeschichtete Platinen für die Herstellung von Resistmustern, einerseits sowie dimensionsstabile, vorzugsweise transparente Kunststoffilme oder -folien, beispielsweise aus Polyestern wie Polyethylenterephthalat oder Polybutylenteraphthalat, andererseits in Frage. Zur Erzielung einer guten Haftung zwischen Träger und photopolymerisierbarer Schicht kann dabei der Träger mechanisch, chemisch und/oder durch Versehen mit einer Haftgrundierung vorbehandelt sein. Ferner können zur Erzielung einer besseren Haftfähigkeit in bekannter Weise auch Haftschichten verwendet werden.

Beispiele sehr geeigneter, fester, photopolymerisierbarer Schichten für die Herstellung von Reliefformen und insbesondere Hochdruckformen enthielten : 35 bis 90 Gew.-% mindestens eines polymeren Bindemittels, insbesondere eines oder mehrerer Copolyamide, eines oder mehrerer Vinylalkohol-Polymere oder eines oder mehrerer elastomerer Homo- oder Copolymere ; 6 bis 60 Gew.-%, insbesondere 8 bis 45 Gew.-%, mindestens einer niedermolekularen Verbindung (a) mit mehr als einer photopolymerisierbaren, olefinisch ungesättigten Doppelbindung oder deren Gemisch mit einer niedermolekularen Verbindung mit nur einer photopolymerisierbaren, olefinisch ungesättigten Doppelbindung ; 0,2 bis 6 Gew.-% eines Photoinitiators (b), 0,001 bis 2 Gew.-% eines Inhibitors gegen thermische Polymerisation ; 0,000 1 bis 1 Gew.-%, vorzugsweise 0,000 1 bis 0,1 Gew.-%, eines Farbstoffs (c1) der Formel (I) ; sowie 0,005 bis 5 Gew.-% eines milden Reduktionsmittels (c2), wobei sich die angegebenen Gewichtsprozente stets auf die Summe aller Bestandteile der Schicht beziehen.

Bezüglich geeigneter photopolymerisierbarer Schichten für die Herstellung von Tiefdruckformen, denen für den Einsatz in dem erfindungsgemäßen Verfahren lösliche Farbstoffe (c1) und Reduktionsmittel (c2) zugemischt werden können, sei auf die DE-OS 31 28 949 verwiesen. Derartige photopolymerisierbare Schichten enthalten vorteilhafterweise als polymeres Bindemittel ein Vinylalkohol-Polymeres oder insbesondere ein alkohollösliches Copolyamid der oben angegebenen Art, vorzugsweise in einer Menge von 20 bis 93 Gew.-%, insbesondere 45 bis 87 Gew.-% ; als Verbindung (a) mit photopolymerisierbaren, olefinisch ungesättigten Doppelbindungen besonders den Diether aus 2 Mol N-Methylolacrylamid und

1 Mol Ethylenglykol, gegebenenfalls in Mischung mit weiteren photopolymerisierbaren Monomeren, vorzugsweise in einer Menge von 2 bis 50 Gew.-%, insbesondere 5 bis 30 Gew.-% ; die in der DE-OS 31 28 949 beschriebenen feinteiligen, harten Füllstoffe, bevorzugt feinteiliges Quarzmehl, in einer Menge von 2 bis 50 Gew.-%, insbesondere 5 bis 25 Gew.-% ; bevorzugt 0,2 bis 5 Gew.-% an Photoinitiator (b) ; Farbstoffe (c1) und Reduktionsmittel (c2) der obengenannten Art und in der obengenannten Menge ; sowie gegebenenfalls weitere übliche Füll- und Zusatzstoffe, wie z. B. Inhibitoren gegen die thermische Polymerisation.

Die Verarbeitung der photopolymerisierbaren Schichten zu den Relief- und/oder Druckformen erfolgt erfindungsgemäß derart, daß die vorzugsweise auf einem Träger aufgebrachte, photopolymerisierbare Schicht bildmäßig mit Licht einer Wellenlänge größer als 450 nm, insbesondere im Wellenlängenbereich des sichtbaren Lichts, belichtet und gleichzeitig oder anschließend vollflächig mit Licht einer Wellenlänge im Bereich von 300 bis 420 nm, vorzugsweise im Bereich von 320 bis 380 nm, bestrahlt wird.

Die Tatsache, daß die photopolymerisierbare Schicht mit Licht in den angegebenen Wellenlängenbereichen bestrahlt wird, bedeutet, daß ein hoher Anteil, vorzugsweise mindestens 80 % der emittierten Strahlung in diesem Wellenbereich liegen soll. Der Unterschied in der Wellenlänge der für die Belichtung verwendeten Strahlungen kann klein sein, er soll für die Praxis jedoch hinreichend sein, das heißt, das für die bildmäßig Belichtung benutzte längerwellige Licht soll den verwendeten Photoinitiator (b) nicht aktivieren und keine bzw. zumindest keine nennenswerte Photopolymerisation in der Schicht auslösen, während das kurzwelligere Licht für die vollflächige Belichtung keine bzw. zumindest keine nennenswerte Wechselwirkung mit dem eingesetzten Farbstoff (c1) zeigen sollte, d. h. die Absorption des Farbstoffes (c1) sollte im Bereich des verwendeten kurzwelligeren Lichtes höchstens 20 %, vorzugsweise nicht mehr als 5 % der maximalen Absorption des Farbstoffes (c1) betragen. Die verwendeten Lichtquellen werden daher vorzugsweise so ausgewählt und auf die photopolymerisierbare Schicht abgestimmt, daß ihre Emissionsmaxima im Bereich der Absorption des verwendeten Photoinitiators (b) bzw. im Bereich des Absorptionsmaximums des verwendeten Farbstoffs (c1) liegen.

Als Lichtquelle für die bildmäßige Belichtung mit dem Licht einer Wellenlänge über 450 nm kommen beispielsweise Glühlampen oder Halogenbrenner, aber auch eisen- oder gallium-dotierte Quecksilberlampen bei Ausfilterung des hohen UV-Anteils durch beispielsweise Gelbfilter in Betracht. Sehr geeignet für die vollflächige Belichtung mit dem Licht im UV-Wellenlängenbereich sind beispielsweise superaktinische Leuchtstoffröhren. Es können aber auch Lichtquellen eingesetzt werden, die sowohl sichtbares als auch UV-Licht emittieren, beispielsweise indem man geeignete Filter verwendet. Ein besonderer Vorteil ist, daß in dem erfindungsgemäßen Verfahren zur Belichtung des photopolymerisierbaren Schicht die üblichen Laser eingesetzt werden können, sofern sie Licht in dem jeweiligen Wellenlängenbereich emittieren. Beispiele für solche Laser sind Argonlaser und Rubinlaser.

Die Belichtungsdauer hängt insbesondere von der Zusammensetzung der photopolymerisierbaren Schicht und der oder den verwendeten Lichtquellen ab und kann beispielsweise zwischen 0,01 und 10 Minuten betragen. Im allgemeinen liegt die Dauer für die bildmäßige Belichtung mit dem langwelligeren Licht im Bereich von einigen Sekunden, beispielsweise 10 sec., bis max. einigen Minuten, etwa 2 Minuten. In der Praxis haben sich für diese Belichtung Zeiten von deutlich weniger als 1 Minute als sehr praktikabel erwiesen. Es hat sich überraschenderweise gezeigt, daß für die vollflächige Belichtung mit dem kurzwelligeren UV-Licht Zeiten von einigen Sekunden, im allgemeinen weniger als 10 Sekunden, insbesondere sogar weniger als 5 Sekunden, ausreichen, um eine hinreichende Photopolymerisation in der Schicht und damit die für die Relief- und Druckform-Herstellung notwendige Löslichkeitsdifferenzierung zwischen den bildmäßig und den nicht bildmäßig belichteten Bereichen der Schicht zu erzielen. Derart kurze Belichtungszeiten sind mit den bisher gebräuchlichen photopolymerisierbaren Schichten nicht zu erzielen.

Die Belichtung der photopolymerisierbaren Schicht mit dem Licht der angegebenen unterschiedlichen Wellenlängenbereiche kann in verschiedener Art und Weise erfolgen. So kann die bildmäßige Belichtung mit dem langwelligeren Licht und die vollflächige Belichtung mit dem kurzwelligeren UV-Licht nacheinander in zwei getrennten Schritten erfolgen, sie können aber auch gleichzeitig in einem Verfahrensschritt durchgeführt werden.

Die bildmäßige Belichtung der photopolymerisierbaren Schicht kann dabei beispielsweise nach der an sich bekannten Methode der Kontaktbelichtung vorgenommen werden, indem eine transparente Bildvorlage, beispielsweise ein Reprofilm, auf die lichtempfindliche Schicht aufgelegt wird und die Schicht durch das Filmpositiv mit dem langwelligeren Licht belichtet wird. Anschließend kann die Bildvorlage von der bildmäßig belichteten Schicht abgezogen und diese vollfächig mit dem kurzwelligeren UV-Licht belichtet werden. Wird eine selbsttragende, d. h. trägerfreie photopolymerisierbare Schicht oder eine Schicht auf einem transparenten, für aktinisches Licht durchlässigen Träger eingesetzt, so ist es auch möglich, gleichzeitig mit der bildmäßigen Belichtung durch das aufgelegte Filmpositiv die Schicht von der Rückseite her vollflächig mit dem kurzwelligeren UV-Licht zu belichten.

Die bildmäßige Belichtung kann aber auch in der Art einer Projektionsbelichtung erfolgen, beispielsweise unter Verwendung einer Repro-Kamera oder durch Projektion eines das Bild tragenden Reproduktionsfilmes auf die photopolymerisierbare Schicht. Im letztgenannten Fall kann gleichzeitig mit der bildmäßigen Belichtung auch die vollflächige Belichtung mit dem UV-Licht vergenommen werden, beispielsweise indem die Lichtquellen für das kurzwelligere UV-Licht zwischen der Ebene des projezierten Filmpositivs und der Ebene der photopolymerisierbaren Schicht angeordnet sind. Auch bei der Projektionsbelichtung kann bei Einsatz einer trägerfreien photopolymerisierbaren Schicht oder einer auf einem transparenten Träger aufgebrachten photopolymerisierbaren Schicht die vollflächige Belichtung mit dem kurzwelligeren UV-Licht von der Schichtrückseite her, ggf. durch den Träger hindurch erfolgen. Im Fall der Projektionsbelichtung, aber auch sonst, kann es zweckmäßig sein, wenn auf die Oberfläche der photopolymerisierbaren Schicht eine dünne, transparente Deckschicht oder Deckfolie aufgebracht ist, um beispielsweise unnötige Sauerstoff-Diffusion in die photopolymerisierbare Schicht zu verhindern. Eine solche Deckschicht oder Deckfolie kann aus den hierfür üblichen und bekannten Materialien, insbesondere Polymeren wie z. B. Polyvinylalkohol, Polyethylen, Polypropylen, Polyvinylchlorid, Polystyrol, Polyester und anderen, gebildet werden.

Gemäß einer weiteren Ausführungsform des erfindungsgemäßen Verfahrens ist es möglich, für die Belichtung der photopolymerisierbaren Schicht eine solche Filmvorlage zu verwenden, deren Bildbereiche nur im sichtbaren Licht, d. h. im Licht einer Wellenlänge größer als 450 nm, absorbieren, während der gesamte Film, einschließlich des Bildes, für UV-Licht im Wellenlängenbereich von 300 bis 420 nm, insbesondere von 320 bis 380 nm, vollständig oder zumindest weitgehend durchlässig ist. Bei Verwendung eines solchen Filmpositivs wird man vorteilhafter Weise die Belichtung mit nur einer einzigen Lichtquelle ausführen, die sowohl sichtbares Licht als auch UV-Licht in den betreffenden Wellenlängenbreichen emittiert. Die Filmvorlage dient dabei nur für das Licht im sichtbaren Wellenlängenbereich als Maske, so daß die photopolymerisierbare Schicht mit dem Licht dieser Wellenlänge bildmäßig belichtet wird, während das kurzwelligere UV-Licht vollflächig durch die Filmvorlage hindurch auf die photopolymerisierbare Schicht auftrifft. Auch in diesem Fall kann die Belichtung als Kontaktbelichtung oder in Form einer Projektionsbelichtung vorgenommen werden.

Wie bereits erwähnt, ist es ein großer Vorteil des erfindungsgemäßen Verfahrens, daß die Belichtung der photopolymerisierbaren Schicht auch mittels eines Lasers vorgenommen werden kann. Für die bildmäßige Belichtung arbeitet man dabei mit einem Laser, der Licht einer Wellenlänge größer als 450 nm, insbesondere sichtbares Licht emittiert. Die bildmäßige Belichtung der photopolymerisierbaren Schicht mit dem Laser erfolgt dabei zweckmäßigerweise so, daß die Bildvorlage mit einem Lese-Laser abgetastet und die hierbei letztlich erhaltene elektrische Information, gegebenenfalls nach Zwischenspeicherung, an den Schreib-Laser weitergegeben wird, der dann die photopolymerisierbare Schicht entsprechend der Hell-Dunkel-Information der bildmäßigen Vorlage punkt- bzw. zeilenweise belichtet. Der Laserstrahl kann über ein Polygon-Spiegelsystem über die photopolymerisierbare Schicht hin- und herbewegt werden, oder er bestrahlt diese Schicht auf einer rotierenden Trommel. Die Belichtung mit dem UV-Licht einer Wellenlänge von 300 bis 420 nm, insbesondere 320 bis 380 nm, kann in diesem Fall, beispielsweise mit einem UV-Laser, zeilenweise parallel zu dem bildmäßig modulierten Laserstrahl erfolgen. Es ist aber auch möglich, die photopolymerisierbare Schicht zuerst mit dem bildmäßig modulierten Laserstrahl der Wellenlänge im Bereich des sichtbaren Lichts zu beschreiben und anschließend die so bildmäßig belichtete photopolymerisierbare Schicht entweder mit einem UV-Laser oder mit den üblichen UV-Licht emittierenden Lichtquellen vollflächig zu belichten. Die Belichtung der photopolymerisierbaren Schicht mit Lasern ist u. a. deswegen besonders vorteilhaft, da in diesem Fall von einem Computer oder Magnetaufzeichnungsmaterial gespeicherte Informationen direkt ohne den Umweg über den reprographischen Film zur Herstellung der Relief- und/oder Druckformen verwendet werden können.

Wie bereits weiter oben erwähnt, wird durch die Belichtung mit dem Licht einer Wellenlänge größer als 450 nm, insbesondere sichtbarem Licht, der Farbstoff (c1) in den angeregten Elektronenzustand versetzt, so daß er durch das milde Reduktionsmittel (c2) reduziert werden kann. Durch diese Reduktion des angeregten Farbstoffs (c1) wird eine Verbindung erzeugt, die bei Bestrahlung der Schicht mit UV-Licht, welches den Photoinitiator (b) aktiviert, die Photopolymerisation in der Schicht verhindert. Da die Belichtung mit dem Licht einer Wellenlänge größer als 450 nm erfindungsgemäß bildmäßig erfolgt, entsteht so in der Schicht ein latentes Bild eines Inhibitors für die Photopolymerisation. Wird die Schicht dann mit UV-Licht im angegebenen Wellenlängenbereich, welches den Photoinitiator (b) aktiviert, bestrahlt, so findet die hierdurch ausgelöste Photopolymerisation nur in den Bereichen der Schicht statt, die nicht mit dem Licht einer Wellenlänge größer als 450 nm bestrahlt worden sind. Die Bildung des Inhibitors für die Photopolymerisation bei Bestrahlung mit dem Licht einer Wellenlänge größer als 450 nm, d. h. dem sichtbaren Licht, erfolgt dabei so schnell und ist so wirksam, daß die Belichtung mit dem sichtbaren Licht und dem die Photopolymerisation auslösenden UV-Licht gleichzeitig erfolgen kann. Es ist sogar möglich, die photopolymerisierbare Schicht zunächst für eine kurze Zeit vollflächig mit dem UV-Licht vorzubelichten und danach erst mit der bildmäßigen Belichtung mit dem sichtbaren Licht einer Wellenlänge größer als 450 nm zu beginnen. Man erhält in allen Fällen überraschenderweise eine derart starke Differenzierung in der Polymerisation zwischen den bildmäßig belichteten und den nichtbildmäßig belichteten Bereichen, daß trotz extrem kurzer Belichtungszeiten einwandfreie, vorlagengetreue Relief- und/oder Druckformen mit ausgezeichneten Eigenschaften und insbesondere einer sehr guten Reliefstruktur erhalten werden können.

Nach der Belichtung der Schicht werden die bildmäßig belichteten, nicht polymerisierten Anteile der Schicht mechanisch entfernt und/oder vorteilhafterweise mit Entwicklerlösungsmitteln ausgewaschen, wobei die nichtbildmäßig belichteten, photopolymerisierten Anteile der Schicht unter Ausbildung der

Relief- und/oder Druckform zurückbleiben. Als Entwicklerlösungsmittel eignen sich die für photopolymerisierbare Schichten der in Rede stehenden Art bekannten und üblichen Lösungsmittel, beispielsweise aliphatische Kohlenwasserstoffe, chlorierte Kohlenwasserstoffe, aromatische Kohlenwasserstoffe, Ester, Ketone, Ether, insbesondere aber Alkohole, Alkohol-Wasser-Gemische oder wäßrige Systeme, insbesondere Wasser als solches. Die resultierende, entwickelte Relief- und/oder Druckform wird nach dem Entwickeln getrocknet und in manchen Fällen zweckmäßigerweise noch einer vollflächigen Nachbelichtung mit UV-Licht im Wellenlängenbereich von 300 bis 420 nm unterworfen. Im Fall der Herstellung von Tiefdruckformen ist eine längere Trocknung bei Temperaturen von ca. 70 bis 100 °C zweckmäßig.

Die erfindungsgemäß hergestellten Relief-Formen lassen sich mit großem Vorteil als Druckformen, insbesondere für den Hochdruck, den Flexodruck und auch den Tiefdruck einsetzen. Die erfindungsgemäß hergestellten Druckformen liefern auch bei hohen Druckauflagen ausgezeichnete Druckergebnisse. Das erfindungsgemäße Verfahren eignet sich darüber hinaus beispielsweise auch zur Herstellung von Offset-Druckplatten, Maskenfilmen oder Resistmustern, beispielsweise für die Herstellung von gedruckten Schaltungen, Leiterplatten etc...

Die Erfindung wird durch die nachfolgenden Beispiele näher erläutert. Die in den Beispielen und den Vergleichsversuchen genannten Teile und Prozente beziehen sich, soweit nicht anders angegeben, auf das Gewicht. Teile verhalten sich zu Volumenteilen wie Kilogramm zu Litern.

### Beispiel 1

Eine 65 %ige methanolische Lösung aus 99,4 Teilen einer photopolymerisierbaren Mischung aus 60 % eines Copolyamids aus Adipinsäure, Hexamethylendiamin, 4,4'-Diaminodicyclohexylmethan und ξ-Caprolactam, 25 % des Diethers aus 1 Mol Ethylenglykol und 2 Molen N-Hydroxymethyl-acrylamid, 13,5 % Benzolsulfonamid und 1,5 % Benzointetrahydropyranylether, 0,6 Teilen des Kaliumsalzes des N-Nitrosocyclohexylhydroxylamins sowie 0,04 Teile Safranin T (C.I. 50 240) wurde schichtförmig auf ein mit einem Haftlack versehenes Stahlblech (Reflexionsgrad ca. 15 %) so aufgegossen, daß nach dem Trocknen bei 70 °C eine photopolymerisierbare Schicht mit einer Schichtstärke von 300μm resultierte. Die photopolymerisierbare Schicht wurde unter Verwendung eines Filmpositivs bildmäßig 30 sek. lang mit einer handelsüblichen 1.000 W-Filmleuchte im Abstand von 1 m belichtet. Unmittelbar anschließend wurde die Schicht 2 sek. lang vollflächig in einem mit superaktinischen Leuchtstoffröhren ($\lambda_{max}$ 350 bis 400 nm) mit Schnellstart-Einrichtung ausgestatteten Flachbelichter belichtet, wobei die Schicht an den Stellen vernetzt wurde, die bei der bildmäßigen Belichtung durch die schwarzen Bereiche des Filmpositivs abgedeckt waren. Anschließend wurden die nichtvernetzten bildmäßig belichteten Schichtanteile mit einem Alkohol-Wasser-Gemisch ausgewaschen.

Es resultierte ein Positiv-Relief, das sich hervorragend als Hochdruckform verwenden ließ. In einer Hochdruckpresse wurden hiermit 100 000 Drukke ausgezeichneter Qualität und ohne Qualitätsverlust hergestellt.

### Vergleichsversuch A

Es wurde wie in Beispiel 1 gearbeitet, jedoch der Zusatz von Safranin T zu der photopolymerisierbaren Schicht unterlassen. Nach der 2 sek. dauernden vollflächigen Belichtung mit den superaktinischen Leuchtstoffröhren war die Schicht in diesem Fall vollständig vollflächig vernetzt. Es gelang nicht, eine Relief-Form herzustellen.

### Beispiel 2

Es wurde wie in Beispiel 1 verfahren, als Farbstoff wurde diesmal jedoch anstelle von Safranin T der Farbstoff Neutralrot (C.I. 50 040) in gleicher Konzentration eingesetzt. Ansonsten entsprachen die Verfahrensbedingungen denen des Beispiels 1. Man erhielt auch in diesem Fall eine hochwertige Hochdruckform, von der mehr als 100 000 Drucke in gleichbleibender Qualität gedruckt werden konnten.

### Beispiel 3

Es wurde wie in Beispiel 1 gearbeitet, diesmal jedoch anstelle von Safranin T als Farbstoff Thionin (C.I. 52 025) eingesetzt. Die Zeit für die vollflächige Belichtung in dem Flachbelichter betrug diesmal 10 sek.. Es resultierte wiederum eine sehr auflagenstarke, positive Hochdruckform.

### Beispiel 4

Es wurde wie in Beispiel 1 aus den gleichen Komponenten eine photopolymerisierbare Schicht auf einem Stahlblech als Träger hergestellt. Die bildmäßige Belichtung der Schicht mit sichtbarem Licht erfolgte diesmal jedoch gleichzeitig mit der vollflächigen Belichtung mit dem UV-Licht. Hierzu wurde zunächst mittels eines roten Diazotypiefilmes eine bildmäßige, positive Filmvorlage hergestellt. Das so erhaltene Filmpositiv war an den opaken Stellen für sichtbares Licht im Wellenlängenbereich von 460 bis

540 nm praktisch undurchlässig (optische Dichte größer 2), während es im UV-Bereich (z. B. bei 365 nm) vollständig, d. h. auch in den bildtragenden Bereichen transparent war (optische Dichte ungefähr 0,13). Dieses Filmpositiv wurde auf die photopolymerisierbare Schicht gelegt. Die Belichtung erfolgte in einem handelsüblichen Belichter mit einem eisendotierten Quecksilbermitteldruckbrenner, der eine Leistung von 2 kW besaß. Nach einer Belichtungszeit von 30 sek. wurde die Schicht mit einem Alkohol-Wasser-Gemisch ausgewaschen. Man erhielt eine positive Relief-Form mit ausgezeichneter Relief-Struktur.

Vergleichsversuch B

Es wurde wie in Beispiel 1 gearbeitet, anstelle des Safranin T wurde diesmal jedoch der Triphenylmethanfarbstoff Kristallviolett (C.I. 42 555) eingesetzt. Die Belichtung der photopolymerisierbaren Schicht erfolgte wie in Beispiel 4 beschrieben. Nach einer Belichtungszeit von nur 2 sek. war die Schicht vollflächig polymerisiert, während sie nach einer Belichtungszeit von nur 1 sek. noch vollkommen löslich war. Es gelang in diesem Fall nicht, eine Relief-Form herzustellen.

Beispiel 5

Eine gemäß Beispiel 3 hergestellte photopolymerisierbare Schicht wurde diesmal in Art einer Projektionsbelichtung bildmäßig belichtet. Das Filmpositiv befand sich in der Filmbühne eines Projektors und wurde im Maßstab 1 : 2 60 sek. lang vergrößert auf die photopolymerisierbare Schicht projeziert. Die Belichtung mit UV-Licht erfolgte gleichzeitig mittels zweier handelsüblicher superaktinischer Leuchtstoffröhren (5 Watt), die aus jeweils 25 cm Entfernung in einem Winkel von je etwa 30° zur Platten-Normalen die Platte vollständig beleuchteten. Nach dieser Belichtung wurde die Platte mit Ethanol/Wasser ausgewaschen. Es resultierte eine einwandfreie Relief-Form, die sich hervorragend für Hochdruckzwecke eignete.

Beispiel 6

Eine 60 %ige wäßrige Lösung eines Gemisches von etwa 60 % eines Polyvinylalkohols (Verseifungsgrad ca. 80 %, mittleres Molekulargewicht etwa 25 000), 20 % des Diethers aus 1 Mol Ethylenglykol und 2 Molen N-Hydroxymethylacrylamid, 18 % Hydroxyethylmethacrylat, 1,4 % Benzoinisopropylether, 0,04 % Safranin T (C.I. 50 240) sowie 0,6 % des Kaliumsalzes des N-Nitrosocyclohexylhydroxylamins wurde schichtförmig auf ein mit einem Haftlack versehenes Stahlblech (Reflexionsgrad ca. 15 %) so aufgegossen, daß nach dem Trocknen bei etwa 70° eine photopolymerisierbare Schicht mit einer Schichtstärke von 300 µm resultierte.

Die Belichtung der photopolymerisierbaren Schicht erfolgte wie in Beispiel 4 beschrieben. Anschließend wurde die Schicht 2 min. in einem Sprühwascher mit 40° warmem Wasser ausgewaschen. Die resultierende positive Relief-Form eignete sich hervorragend als Hochdruckform. Mit ihr konnten in einer Druckpresse mehr als 100 000 Abzüge ohne sichtbare Klischeeabnutzung gedruckt werden.

Vergleichsversuch C

Es wurde wie in Beispiel 6 gearbeitet, diesmal jedoch auf den Zusatz von Safranin T in der photopolymerisierbaren Schicht verzichtet. Es war nicht möglich, nach der Arbeitsweise von Beispiel 6 eine Relief-Form herzustellen.

Vergleichsversuch D

Es wurde wie in Beispiel 6 gearbeitet, diesmal jedoch auf den Zusatz des Kaliumsalzes des N-Nitrosocyclohexyl-hydroxylamins in der photopolymerisierbaren Schicht verzichtet. Es war nicht möglich, nach der Arbeitsweise von Beispiel 6 eine Relief-Form herzustellen.

Beispiel 7

Auf ein mit einer Haftschicht aus Polyurethan versehenes 240 µm starkes Stahlblech wurde eine 200 µm dicke photopolymerisierbare Schicht folgender Zusammensetzung aufgebracht : 61 Teile eines in wäßrigem Alkohol löslichen Mischpolyamids aus etwa gleichen Teilen Hexamethylendiamin-Adipat, 4,4'-Diamino-dicyclohexylmethan-Adipat und Caprolactam, 27 Teile des Diethers aus 1 Mol Ethylenglykol und 2 Molen N-Methylolacrylamid, 10 Teilen feinteiligem Quarzmehl (Typ F 600 der Fa. Quarz-Werke Frechen), 2 Teile Benzildimethylketal, 0,3 Teile des Kaliumsalzes des N-Nitrosocyclohexylhydroxylamins sowie 0,02 Teile des Farbstoffs Safranin T (C.I. 50 240). Dabei lagen die Schichtbestandteile in inniger Mischung vor.

Die photopolymerisierbare Schicht wurde durch eine negative, autotypische Tiefdruckvorlage 30 sek. lang mit dem sichtbaren Anteil des Lichtes einer eisendotierten Quecksilber-Lampe belichtet. Der Anteil des emittierten Lichtes einer Wellenlänge kleiner als 450 nm wurde mit einem Gelbfilter ausgefiltert. Sofort danach wurde die Bildvorlage von der Schicht entfernt und die Schicht vollflächig 1 sek. lang mit

superaktinischen Leuchtstoffröhren belichtet. Anschließend wurden die löslichen, nicht-polymerisierten Anteile der Schicht mit einem Alkohol-Wasser-Gemisch ausgewaschen. Die resultierende Tiefdruckform wurde 30 Minuten bei 80 °C getrocknet. Die Näpfchen waren ca. 30μm tief und wiesen steilen Flanken auf. Mit dieser Tiefdruckform wurden qualitativ hochwertige Drucke erhalten.

Vergleichsversuch E

Wurde wie in Beispiel 7 gearbeitet, jedoch auf den Zusatz von Safranin T verzichtet, war die Schicht bei vollflächiger UV-Belichtung von 0,5 sek. noch vollständig löslich, während nach 1 sek. Belichtungszeit die Platte vollständig polymerisiert war. Es war nicht möglich, eine Tiefdruckform herzustellen.

Beispiel 8

Analog Beispiel 7 wurde auf einem Stahlblech eine photopolymerisierbare Schicht folgender Zusammensetzung hergestellt: 61 Teile eines teilverseiften Polyvinylalkohols (Verseifungsgrad 80 bis 82 %, Molekulargewicht ca. 25 000), 27 Teile des Diethers aus 1 Mol Ethylenglykol und 2 Molen N-Methylolacrylamid, 10 Teilen feinteiligen Quarzmehls (wie in Beispiel 7), 2 Teilen Benzildimethylketal, 0,3 Teilen des Kaliumsalzes des N-Nitrosocyclohexylhydroxylamins sowie 0,02 Teilen des Farbstoffs Safranin T (C.I. 50 240). Die photopolymerisierbare Schicht wurde wie in Beispiel 7 beschrieben belichtet und nachbehandelt. Man erhielt eine Tiefdruckform mit 25μm tiefen Näpfchen mit steilen Flanken. Auch mit dieser Tiefdruckform wurden hervorragende Druckergebnisse erzielt.

Beispiel 9

Es wurde wie in Beispiel 1 gearbeitet, anstelle des Kaliumsalzes des N-Nitrosocyclohexyl-hydroxylamins wurden diesmal jedoch als Reduktionsmittel 0,3 Teile N-Allylthioharnstoff und als thermischer Polymerisationsinhibitor 0,1 Teile Hydrochinonmonomethylether eingesetzt. Die vollflächige Belichtung mit dem UV-Licht betrug diesmal 4 sek. Auch in diesem Fall resultierte ein einwandfreies Positif-Relief, das sich sehr gut als Hochdruckform eignete.

**Patentansprüche**

1. Positiv arbeitendes Verfahren zur Herstellung von Relief- und/oder Druckformen, bei dem man eine photopolymerisierbare Schicht, enthaltend

a) mindestens eine Verbindung mit mindestens einer photopolymerisierbaren olefinisch ungesättigten Doppelbindung,

b) mindestens einen Photoinitiator, der bei der Belichtung mit Licht im Wellenlängenbereich von 300 bis 420 nm eine rasche Photopolymerisation in der Schicht auslöst, sowie

c) weitere Zusatzstoffe,

bildmäßig belichtet, wodurch in den belichteten Bereichen die Polymerisationsfähigkeit unterdrückt wird ; durch eine weitere Belichtung mit Licht im Wellenlängenbereich von 300 bis 420 nm die zunächst nicht belichteten, noch photopolymerisierbaren Bereiche der Schicht polymerisiert ; und anschließend die Relief- und/oder Druckform durch Entfernen, insbesondere Auswaschen, der nicht-polymerisierten Bereiche der Schicht entwickelt, dadurch gekennzeichnet, daß die Schicht eine Kombination enthält von

c 1) 0,000 1 bis 1 Gew.-%, bezogen auf die Gesamtmasse der Schicht, eines löslichen Farbstoffs der Formel (I)

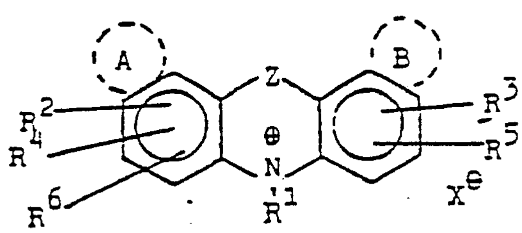

(I)

worin bedeuten

Z : N, O, S oder $CR^7$ ;

$R^1$ : ein Wasserstoffatom, $C_1$-$C_4$-Alkyl, ggf. substituiertes Phenyl oder Naphthyl ;

$R^2$, $R^3$ : gleiche oder verschiedene Reste aus der gruppe Wasserstoffatom, Hydroxy, $C_1$-$C_4$-Alkoxy, Phenoxy, ggf. substituiertes Diarylmethyl und $NR_2$ [mit R = H, ggf. substituierten Alkyl-, Aryl- oder Aralkylresten, wobei die beiden Reste R gleich oder verschieden sein können] ;

$R^4$, $R^5$ : gleiche oder verschiedene Reste aus der Gruppe Wasserstoffatom, $C_1$-$C_4$-Alkyl-, Phenyl-,

Hydroxy-, $C_1$-$C_4$-Alkoxy-, Sulfo- oder $NR_2$-Gruppe [mit R = H, ggf. substituierten Acyl-, Alkyl-, Aryl- oder Aralkylresten, wobei die beiden Reste R gleich oder verschieden sein können] ;

$R^6$ : ein Wasserstoffatom, eine Hydroxy-, $C_1$-$C_4$-Alkoxy-, Carboxyl-, Carbalkoxy-, N-Acylamino-Gruppe oder ein Halogenatom ;

$R^7$ : ein Wasserstoffatom, eine $C_1$-$C_4$-Alkyl- oder ggf. substituierte Aryl- oder Aralkyl-Gruppe ;

$X^{\ominus}$ : ein Säureanion ;

A, B : Wasserstoffatome oder ein ankondensiertes Benzo-, Naphtho- oder Heterocyclensystem mit Ankondensation in a-, b- oder c-Stellung, wobei die Reste A und B gleich oder verschieden sein können mit der Maßgabe, daß, wenn A ein ankondensiertes Ringsystem der genannten Art ist, einer der Reste $R^2$ oder $R^4$ entfällt ;

und

c 2) einer hinreichenden Menge eines milden Reduktionsmittels für den Farbstoff (c 1), das den Farbstoff (c 1) in Abwesenheit von aktinischem Licht nicht reduziert, den durch Belichtung mit Licht einer Wellenlänge größer als 450 nm, insbesondere sichtbarem Licht, in den angeregten Elektronenzustand versetzten Farbstoff (c 1) jedoch reduzieren kann ;

daß man das bildmäßige Belichten der Schicht mit Licht einer Wellenlänge größer als 450 nm, insbesondere im Wellenlängenbereich des sichtbaren Lichts, durchführt, wodurch in der Schicht under Reduktion des Farbstoffes (c 1) bildmäßig eine Verbindung erzeugt wird, die eine Photopolymerisation in der Schicht bei Aktivierung des Photoinitiators (b) inhibiert bzw. den Photoinitiator (b) inaktiviert, und daß die weitere Belichtung der Schicht gleichzeitig oder anschließend vollflächig erfolgt, wodurch die nicht mit dem längerwelligen Licht belichteten Bereiche der Schicht polymerisiert werden.

2. Verfahren nach Anspruch 1, dadurch gekennzeichnet, daß die Schicht als Farbstoff (c 1) einen löslichen Phenoxaziniumfarbstoff der Formel (I) mit Z = O enthält.

3. Verfahren nach Anspruch 1, dadurch gekennzeichnet, daß die Schicht als Farbstoff (c 1) einen löslichen Phenaziniumfarbstoff der Formel (I) mit Z = N enthält.

4. Verfahren nach Anspruch 1, dadurch gekennzeichnet, daß die Schicht als Farbstoff (c 1) einen löslichen Thiaziniumfarbstoff der Formel (I) mit Z = S enthält.

5. Verfahren nach Anspruch 1, dadurch gekennzeichnet, daß die Schicht als Farbstoff (c 1) einen löslichen Acridiniumfarbstoff der Formel (I) mit Z = $CR^7$ enthält.

6. Verfahren nach einem der Ansprüche 1 bis 5, dadurch gekennzeichnet, daß die Schicht als schwaches Reduktionsmittel (c 2) ein Salz des N-Nitroso-cyclohexylhydroxylamins enthält.

7. Verfahren nach einem der Ansprüche 1 bis 5, dadurch gekennzeichnet, daß die Schicht als schwaches Reduktionsmittel (c 2) N-Allylthioharnstoff enthält.

8. Verfahren nach einem der Ansprüche 1 bis 7, dadurch gekennzeichnet, daß die Schicht ein in Mischung mit den anderen Komponenten verträgliches, polymeres Bindemittel enthält.

9. Verfahren nach einem der Ansprüche 1 bis 8, dadurch gekennzeichnet, daß die Schicht weitere übliche und an sich bekannte Zusatzstoffe enthält.

10. Verfahren nach Anspruch 3, dadurch gekennzeichnet, daß die Schicht als Farbstoff (c 1) Neutralrot (C.I. 50 040) oder Safranin T (C.I. 50 240) enthält.

11. Verfahren nach Anspruch 4, dadurch gekennzeichnet, daß die Schicht als Farbstoff (c 1) Thionin (C.I. 52 025) oder Methylenblau (C.I. 52 015) enthält.

12. Verfahren nach einem der Ansprüche 1 bis 11, dadurch gekennzeichnet, daß die Schicht mit dem Licht einer Wellenlänge größer als 450 nm für eine Dauer von 0,01 bis 10 Minuten bildmäßig belichtet wird.

13. Verfahren nach einem der Ansprüche 1 bis 12, dadurch gekennzeichnet, daß die Zeitdauer für die vollflächige Belichtung der Schicht mit dem Licht einer Wellenlänge im Bereich von 300 bis 420 nm im Bereich 0,1 bis 30 Sekunden liegt.

14. Verfahren nach einem der Ansprüche 1 bis 13, dadurch gekennzeichnet, daß die lichtempfindliche photopolymerisierbare Schicht auf einem dimensionsstabilen Träger aufgebracht ist.

15. Verfahren nach einem der Ansprüche 1 bis 14, dadurch gekennzeichnet, daß die bildmäßig Belichtung mit dem längerwelligen Licht in Art einer Projektionsbelichtung erfolgt.

16. Verfahren nach Anspruch 15, dadurch gekennzeichnet, daß das Licht einer Wellenlänge im Bereich von 300 bis 420 nm seitlich vom Strahlengang der Projektionsbelichtung vollflächig auf die Schicht eingestrahlt wird.

17. Verfahren nach Anspruch 14, dadurch gekennzeichnet, daß die photopolymerisierbare Schicht auf einem transparenten Träger aufgebracht ist, die bildmäßige Belichtung mit dem längerwelligen Licht von der Seite der dem Träger abgewandten Schichtoberfläche her erfolgt und die vollflächige Belichtung mit dem Licht einer Wellenlänge im Bereich von 300 bis 420 nm durch den Träger hindurch erfolgt.

18. Verfahren nach einem der Ansprüche 1 bis 14, dadurch gekennzeichnet, daß für die bildmäßige Belichtung ein Film verwendet wird, dessen bildtragende Bereiche nur längerwelliges Licht einer Wellenlänge größer als 450 nm absorbieren, und die Belichtung der Schicht mit dem längerwelligen Licht einer Wellenlänge größer 450 nm und dem Licht einer Wellenlänge im Bereich von 300 bis 420 nm durch den Film hindurch erfolgt.

19. Verfahren nach einem der Ansprüche 1 bis 14, dadurch gekennzeichnet, daß die bildmäßige Belichtung der Schicht mit einem Laser erfolgt, der Licht einer Wellenlänge größer 450 nm emittiert,

wobei die Belichtung mit dem Licht einer Wellenlänge im Bereich von 300 bis 420 nm entweder durch nicht bildmäßig moduliertes Licht zeilenweise parallel zu dem bildmäßig modulierten Laserstrahl erfolgen kann oder auch vollflächig nach dem Beschreiben der Schicht mit dem bildmäßig modulierten Laser.

**Claims**

1. A positive-working process for the production of relief and/or printing plates, wherein a photopolymerizable layer containing

a) one or more compounds possessing one or more photopolymerizable olefinically unsaturated double bonds,

b) one or more photoinitiators which, when exposed to light having a wavelength of from 300 to 420 nm, initiate rapid photopolymerization in the layer, and

c) other additives,

is exposed imagewise, with the result that the polymerizability is suppressed in the exposed areas ; the initially unexposed, still photopolymerizable areas of the layer are polymerized by a further exposure to light having a wavelength of from 300 to 420 nm ; and the relief and/or printing plate is then developed by removing, in particular by washing out, the unpolymerized areas of the layer, wherein the layer contains a combination of

c 1) from 0.000 1 to 1 % by weight, based on the total mass of the layer, of a soluble dye of the formula (I)

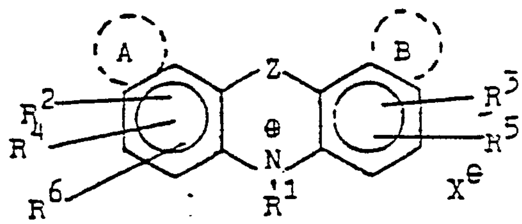

(I)

where Z is N, O, S or $CR^7$,

$R^1$ is hydrogen, $C_1$-$C_4$-alkyl, unsubstituted or substituted phenyl or naphthyl,

$R^2$ and $R^3$ are identical or different radicals from the group comprising hydrogen, hydroxyl, $C_1$-$C_4$-alkoxy, phenoxy, unsubstituted or substituted diarylmethyl and $NR_2$ [where R is H or a substituted or unsubstituted alkyl, aryl or aralkyl radical, and the two radicals R can be identical or different] ;

$R^4$ and $R^5$ are identical or different radicals from the group comprising hydrogen, $C_1$-$C_4$-alkyl, phenyl, hydroxyl, $C_1$-$C_4$-alkoxy, sulfo and $NR_2$ [where R is H or an unsubstituted or substituted acyl, alkyl, aryl or aralkyl radical, and the two radicals R can be identical or different],

$R^6$ is hydrogen, hydroxyl, $C_1$-$C_4$-alkoxy, carboxyl, carbalkoxy, N-acylamino or halogen,

$R^7$ is hydrogen, $C_1$-$C_4$-alkyl or an unsubstituted or substituted aryl or aralkyl group,

$X^-$ is an acid anion,

and A and B can be identical or different and are each hydrogen or a benzocyclic, naphthocyclic or heterocyclic system which is fused in the a-, b- or c-position, with the proviso that, if A is a fused ring system of the stated type, one of the radicals $R^2$ and $R^4$ is absent,

and

c 2) a sufficient amount of a mild reducing agent which does not reduce the dye (c1) in the absence of actinic light, but is capable of reducing this dye when it has been converted to the excited electronic state by exposure to light having a wavelength longer than 450 nm, in particular light in the visible wavelength range,

wherein the layer is exposed imagewise to light having a wavelength longer than 450 nm, in particular to light in the visible wavelength range, with the result that, in the layer, the dye (c1) is reduced imagewise to produce a compound which inhibits photopolymerization in the layer when the photo-initiator (b) is activated, or inactivates this photo-initiator, and wherein simultaneously or subsequently, the layer is further exposed uniformly, with the result that those areas of the layer which were not exposed to the light of relatively long wavelength undergo polymerization.

2. A process as claimed in claim 1, wherein the layer contains, as the dye (c1), a soluble phenoxazinium dye of the formula (I) where Z is O.

3. A process as claimed in claim 1, wherein the layer contains, as the dye (c1), a soluble phenazinium dye of the formula (I) where Z is N.

4. A process as claimed in claim 1, wherein the layer contains, as the dye (c1), a soluble thiazinium dye of the formula (I) where Z is S.

5. A process as claimed in claim 1, wherein the layer contains, as the dye (c1), a soluble acridinium dye of the formula (I) where Z is $CR^7$.

6. A process as claimed in any one of claims 1 to 5, wherein the layer contains a salt of N-nitrosocyclohexylhydroxylamine as the weak reducing agent (c2).

7. A process as claimed in any one of claims 1 to 5, wherein the layer contains N-allylthiourea as the weak reducing agent (c2).

8. A process as claimed in any one of claims 1 to 7, wherein the layer contains a polymeric binder which is compatible in a mixture with the other components.

9. A process as claimed in any one of claims 1 to 8, wherein the layer contains further customary additives which are known per se.

10. A process as claimed in claim 3, wherein the layer contains, as the dye (c1), neutral red (C.I. 50 040) or safranine T (C.I. 50 240).

11. A process as claimed in claim 4, wherein the layer contains, as the dye (c1), thionine (C.I. 52 025) or methylene blue (C.I. 52 015).

12. A process as claimed in any one of claims 1 to 11, wherein the layer is exposed imagewise, for from 0.01 to 10 minutes, to light having a wavelength longer than 450 nm.

13. A process as claimed in any one of claims 1 to 12, wherein the uniform exposure of the layer to light having a wavelength of from 300 to 420 nm lasts from 0.1 to 30 seconds.

14. A process as claimed in any one of claims 1 to 13, wherein the photosensitive photopolymerizable layer is applied onto a dimensionally stable base.

15. A process as claimed in any one of claims 1 to 14, wherein the imagewise exposure to relatively long wavelength light is carried out by a projection exposure method.

16. A process as claimed in claim 15, wherein light having a wavelength of from 300 to 420 nm is directed laterally with respect to the beam path of the projection exposure, and falls uniformly on the layer.

17. A process as claimed in claim 14, wherein the photopolymerizable layer is applied onto a transparent base, imagewise exposure to the relatively long wavelength light is effected from the side of that surface of the layer which faces away from the base, and uniform exposure to light having a wavelength of from 300 to 420 nm is carried out through the base.

18. A process as claimed in any one of claims 1 to 14, wherein the imagewise exposure is carried out using a film whose image-bearing areas absorb only light having a wavelength longer than 450 nm, and exposure of the layer to this relatively long wavelength light and to light having a wavelength of from 300 to 420 nm is carried out through the film.

19. A process as claimed in any one of claims 1 to 14, wherein the layer is exposed imagewise using a laser which emits light having a wavelength longer than 450 nm, and exposure to light having a wavelength of from 300 to 420 nm can be carried out either line by line, parallel to the imagewise modulated laser beam, by means of light which is not modulated imagewise, or can be effected uniformly after the layer has been inscribed using the imagewise modulated laser.

## Revendications

1. Procédé, opérant en positif, pour la fabrication de formes d'impression et/ou en relief, dans lequel, on expose, selon une image, une couche photopolymérisable contenant :

a) au moins un composé photopolymérisable ayant au moins une double liaison insaturée oléfiniquement,

b) au moins un photoinitiateur qui, par exposition à une lumière d'une zone de longueur d'onde de 300 à 420 nm, déclenche dans la couche une soudaine photopolymérisation,

c) d'autres additifs

grâce à quoi la faculté de polymérisation est affaiblie dans les zones exposées ; par une autre exposition à une lumière d'une zone de longueur d'onde de 300 à 420 nm on polymérise la zone de couche d'abord non exposée, encore photopolymérisable, puis on développe la forme en relief et/ou d'impression par élimination, en particulier par lavage, de la zone de couche non polymérisée, caractérisé par le fait que la couche contient une combinaison de

c 1) 0,000 1 à 1 % en poids, rapporté à la masse totale de la couche, d'un colorant soluble de formule I

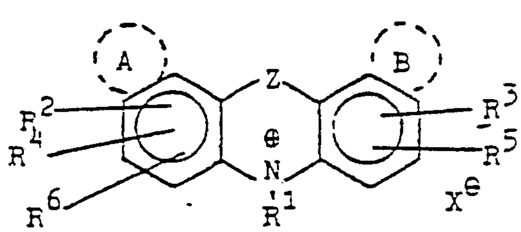

(I)

où

Z représente N, O, S ou $CR^7$

$R^1$ : un atome d'hydrogène, alkyle en $C_1$-$C_4$, phényle éventuellement substitué, ou naphthyle,

$R^2$, $R^3$ : des restes, identiques ou différents, du groupe atome d'hydrogène, hydroxy, alcoxy en $C^1$-$C_4$, phénoxy, diarylméthyle éventuellement substitué, et $NR_2$ [avec R = H, restes alkyle, aryle ou aralkyle, éventuellement substitués, les deux R pouvant être identiques ou différents] ;

$R^4$, $R^5$ : restes identiques ou différents du groupe atome d'hydrogène, du groupe alkyle en $C_1$-$C_4$, phényle, hydroxy, alcoxy en $C_1$-$C_4$, sulfo ou $NR_2$ [avec R = H, restes acyle, alkyle, aryle ou aralkyle, éventuellement substitués, les deux restes R pouvant être identiques ou différents] ;

$R^6$ : un atome d'hydrogène, un groupe hydroxy, alcoxy en $C_1$-$C_4$, carboxyle, carbalcoxy, N-acylamino ou un atome d'halogène ;

$R^7$ : un atome d'hydrogène, alkyle en $C_1$-$C_4$ ou aryle ou aralkyle éventuellement substitué

X : un anion d'acide

A, B : soit des atomes d'hydrogène, soit un système benzo-, naphto- ou hétérocyclique fixé par condensation en position a, b, ou c, les restes A et B pouvant être identiques ou différents, sous réserve que, lorsque A est un système cyclique fixé fait par condensation, du type indiqué, un des restes $R^2$ ou $R^4$ disparaît ; et

c 2) une quantité suffisante d'un agent de réduction doux pour le colorant (c1), qui ne réduit pas le colorant (c1) en l'absence de lumière actinique, mais peut réduire le colorant (c1) mis dans un état électronique excité par exposition à la lumière d'une longueur d'onde supérieure à 450 nm, en particulier la lumière visible ;

que l'on effectue l'exposition, selon une image, de la couche avec une lumière d'une longueur d'onde supérieure à 450 nm, en particulier dans la zone de longueur d'onde de la lumière visible, grâce à quoi est produit dans la couche, selon l'image, par réduction du colorant (c1), un composé qui inhibe une photopolymérisation dans la couche par activation du photoinitiateur (b) ou inactive le photoinitiateur et que l'autre exposition de la couche s'opère sur toute la surface simultanément ou successivement, grâce à quoi les zones de la couche non exposées à la lumière d'ondes plus longues sont polymérisées.

2. Procédé selon la revendication 1, caractérisé par le fait que la couche contient comme colorant (c1) un colorant de phénoxyazinium soluble de formule I, avec Z = O.

3. Procédé selon la revendication 1, caractérisé par le fait que la couche contient comme colorant (c1) un colorant de phénazinium soluble de formule I, avec Z = N.

4. Procédé selon la revendication 1, caractérisé par le fait que la couche contient comme colorant (c1) un colorant de thiazinium soluble de formule I, avec Z = S.

5. Procédé selon la revendication 1, caractérisé par le fait que la couche contient comme colorant (c1) un colorant d'acridinium soluble de formule I avec Z = $CR^7$.

6. Procédé selon l'une des revendications 1 à 5, caractérisé par le fait que la couche contient, comme réducteur faible (c2), un sel de N-nitrosocyclohexylhydroxylamine.

7. Procédé selon l'une des revendications 1 à 5, caractérisé par le fait que la couche contient, comme réducteur faible (c2) une N-allylthiourée.

8. Procédé selon l'une des revendications 1 à 7, caractérisé par le fait que la couche contient un liant polymère compatible, en mélange avec les autres composants.

9. Procédé selon l'une des revendications 1 à 8, caractérisé par le fait que la couche contient d'autres additifs usuels, connus en soi.

10. Procédé selon la revendication 3, caractérisé par le fait que la couche contient comme colorant (c1) Rouge neutre (Neutralrot) (C.I. 50 040) ou Safranine T (C.I. 50 240).

11. Procédé selon la revendication 4 caractérisé par le fait que la couche contient comme colorant (c1), Thionine (C.I. 52 025) ou Bleu de méthylène (C.I. 52 015).

12. Procédé selon l'une des revendications 1 à 11, caractérisé par le fait que la couche est exposée, selon l'image, à la lumière d'une longueur d'onde supérieure à 450 nm pendant une durée de 0,01 à 10 minutes.

13. Procédé selon l'une des revendications 1 à 12, caractérisé par le fait que la durée de l'exposition, sur toute la surface de la couche, à de la lumière d'une longueur d'onde comprise entre 300 et 420 nm, est comprise entre 0,1 et 30 secondes.

14. Procédé selon l'une des revendications 1 à 13, caractérisé par le fait que la couche photopolymérisable, sensible à la lumière, est appliquée sur un support stable en dimensions.

15. Procédé selon l'une des revendications 1 à 14, caractérisé par le fait que l'exposition, selon une image, à une lumière d'ondes longues, s'effectue sous forme d'une exposition par projection.

16. Procédé selon la revendication 15, caractérisé par le fait que la lumière d'une longueur d'onde comprise entre 300 et 420 nm est projetée sur toute la surface de la couche, latéralement par rapport au faisceau lumineux de projection.

17. Procédé selon la revendication 14, caractérisé par le fait que la couche photopolymérisable est appliquée sur un support transparent, l'exposition, selon image, est effectuée avec la lumière d'ondes longues venant du côté de la surface de la couche écartée du support et l'exposition sur toute la surface est effectuée à travers le support avec de la lumière d'une longueur d'onde comprise entre 300 et 420 nm.

18. Procédé selon l'une des revendications 1 à 14, caractérisé par le fait que, pour l'exposition selon

une image, on utilise un film dont les zones portant l'image n'absorbent que de la lumière d'ondes longues d'une longueur d'onde supérieure à 450 nm et l'exposition de la couche s'effectue à travers le film avec de la lumière d'onde longue d'une longueur d'onde supérieure à 450 nm et de la lumière d'une longueur d'onde comprise entre 300 et 420 nm.

19. Procédé selon l'une des revendications 1 à 14, caractérisé par le fait que l'exposition selon l'image de la couche s'effectue avec un laser qui émet de la lumière d'une longueur d'onde supérieure à 450 nm, l'exposition à la lumière d'une longueur d'onde comprise entre 300 et 420 nm pouvant s'effectuer, soit par la lumière non modulée, selon l'image, en lignes parallèlement au rayon laser modulé selon l'image, soit par le laser modulé, selon l'image, sur toute la surface, suivant la description de la couche.